# EUROPEAN PATENT APPLICATION

(11) **EP 3 285 278 A1**
(43) Date of publication of application: **21.02.2018**
(21) Application number: 16184239.8
(22) Date of filing: 16.08.2016
(51) Int. Cl.: H01J 37/02, H01J 37/26, C23C 16/44, H01J 37/32

(54) **MAGNET USED WITH A PLASMA CLEANER**

(71) Applicant: FEI Company, Hillsboro, OR 97124-5793 (US)
(72) Inventor: Svéda, Viktor, 602 00 Brno (CZ); Novak, Libor, 639 00 Brno (CZ); Stepánek, Václav, 679 03 Olomucany (CZ); Poloucek, Pavel, 61200 Brno (CZ)
(74) Representative: Bakker, Hendrik

(57) **Abstract**

A plasma generator is located outside the vacuum chamber and generates neutral reactive particles and charged particles. A magnet positioned outside the plasma generator deflects the charged particles, preventing some or all of them from entering the vacuum chamber, thereby preventing secondary plasma sources from forming in the vacuum chamber, while allowing neutral reactive particles to enter the vacuum chamber to reduce contamination.

## Description

### Technical Field of the Invention

The present invention relates to plasma cleaning of vacuum chambers, and more particularly to a method and apparatus for improved plasma cleaning.

### Background of the Invention

Charged particle beam systems, such as electron microscopes and focused ion beam systems, are used in a variety of applications for forming images, creating patterns on work pieces, and identifying and analyzing components in sample materials. Such systems operate on a work piece in a vacuum chamber. Contaminants in the vacuum chamber can adversely affect the interaction of the beam with the work piece surface and can interfere with the secondary emissions, such as X-rays and emitted electrons, used for sample analysis. Cleanliness of the vacuum chamber and the work piece is critical because charged particle beam processing and analysis occurs at near the atomic level. A pristine environment is required for creating structures and performing analysis at the precision level required for nanotechnology.

Sources of contamination include, for example, fingerprints, cleaning solvent residues, lubricants, and residue process chemicals used previously in the vacuum chamber, as well as the work piece itself. Contamination may also be present on the internal components of the instrument. For example, a film of hydrocarbons will accumulate on the work piece surface if left exposed to atmospheric conditions for any length of time. Organic compounds that evaporate from these sources of contamination can be dissociated by irradiation of the beam to deposit organic compounds onto the work piece and onto surfaces within the specimen chamber.

Cleaning components of the vacuum chamber with solvents and abrasive cleaners is inadequate. Purging the vacuum system with a gas, such as dry nitrogen, is slow and inefficient.

Plasma cleaners have been developed for cleaning microscope systems and work pieces. In some systems, low-temperature plasma is generated within the vacuum chamber of the processing equipment. Such vacuum systems have to be designed to withstand the direct contact with the plasma. In other systems, referred to as "downstream" plasma cleaners, a plasma is generated outside of the vacuum chamber and particles from the plasma generator travel into the vacuum system. The present applicant, FEI Company, Hillsboro, Oregon, offers a downstream plasma cleaner as an accessory to its microscopes. Downstream plasma cleansers are also described, for example, in U.S. Pat. No. 5,312,519 to Sakai, et al, and U.S. Pat. Nos. 6,610,247 and 6,105,589 to Vane.

Plasma cleaning systems provide energy to ignite and maintain a plasma by ionizing a source gas. Besides producing ions, plasma systems also generate radicals, that is, reactive neutral atoms or molecules, from the source gas. The types of ions and radicals generated depend on the source gas and the energy that produces the plasma. For example, if air is used as the source gas, oxygen and nitrogen radicals will be generated. U.S. 6,105,589 describes controlling the excitation energy of the plasma to limit nitrogen ion production that destroys oxygen radicals.

An opening in the plasma chamber allows ions, electrons, and neutral particles, both reactive and non-reactive, to leave the plasma generator and enter the vacuum chamber. The reactive radicals, such as oxygen radicals, react with the hydrocarbon contaminants within the vacuum chamber and form volatile components that can be easily pumped out of the system by the vacuum system. This is the intended reaction and the functional principle of this type of plasma cleaners.

Ions entering the vacuum chamber from the plasma generator can be accelerated toward components within the vacuum chamber and damage those component. The charged particles from the vacuum generator can also produce an electrical field strong enough to ionize other neutral atoms in the vacuum chamber and create secondary, uncontrolled plasma sources decimeters away from the plasma cleaner outlet. Such secondary plasma sources in the vicinity of sensitive equipment in the vacuum chamber, such as detectors and precision stages, can quickly damage this type of equipment.

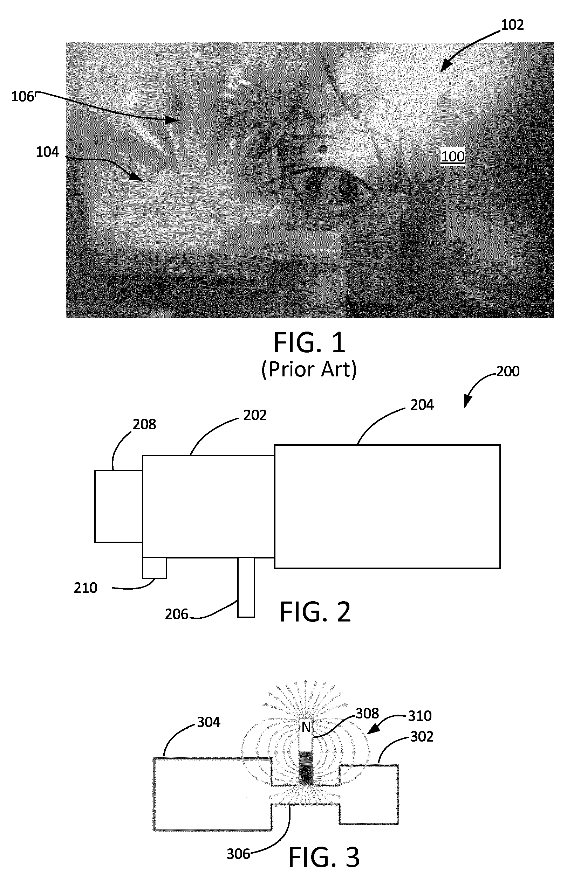

FIG. 1 is a photograph of the inside of a vacuum chamber 100 of a dual beam system, including an electron beam column and an ion beam column. The bright regions reveal intensive secondary plasma sources. Region 102 is a plasma near the point where a plasma cleaner is connected to vacuum chamber 100 and region 104 is a plasma self-generated near the sample position below the electron beam column and the ion beam column.

To prevent ignition of the secondary plasma sources, the power of the plasma generator has to be reduced. However, reducing the power also reduces the amount of generated reactive radicals, which increases cleaning times causing undesirable downtime of the machine.

### Summary of the Invention

An object of the invention is to provide an improvement to downstream plasma cleaners so that they can be operated at higher power with improved efficiency without causing damage to the system being cleaned.

A magnetic field having a component perpendicular to the plasma cleaner passage is used to eliminate or significantly reduce the number of electrons and ions entering a vacuum chamber from a plasma generator while allowing neutral reactive particles, which react with the contamination, to enter the vacuum chamber.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the scope of the invention as set forth in the appended claims.

### Brief Description of the Drawings

For a more thorough understanding of the present invention, and advantages thereof, reference is now made to the following descriptions taken in conjunction with the accompanying drawings, in which:
FIG. 1 is a photograph of a plasma within a vacuum chamber of a charged particle beam system.
FIG. 2 is a schematic illustration of a plasma cleaner with a magnet attached.
FIG. 3 is a schematic illustration of a magnet attached to a passage between the attached plasma cleaner and a charged particle beam system.
FIG. 4 is a schematic illustration of the vacuum chamber and plasma source.
FIG. 5 is a chart showing the cleaning efficiency of the plasma cleaners under different conditions.
FIG. 6 is a photograph, similar to that of FIG. 1, but in a system that includes a magnet field to reduce charged particles entering the vacuum chamber.

### Detailed Description of Preferred Embodiments

Figure 2 shows a schematic of a plasma cleaner 200 that includes a plasma chamber 202 powered by a power source, such as a radio frequency generator 204. A leak valve 206 connected to a gas supply (not shown) supplies gas into the plasma chamber 202. A flange 208 connects to a mating part on a charged particle beam system (not shown). A magnet 210 adjacent to the outlet of the plasma chamber provides a magnetic field that causes a Lorentz force on the charged particles leaving the plasma, altering their trajectory so that most of the charged particles do not reach the vacuum chamber of the charged particle beam system.

The preferred type of magnet and the field strength will depend on the particular application, and more specifically, on the design of both the plasma cleaner and the vacuum chamber being cleaned. Factors to be considered in determining the magnet size, position and strength are the dimensions of the plasma cleaner and its outlet, and the distance between the plasma cleaner and the target vacuum chamber. Two constraints determine optimal magnet selection: 1) The magnet lateral dimensions should be similar to the diameter of the plasma cleaner outlet; and 2) The magnet should be as strong as practically possible, but the magnetic field should not extend far from the plasma cleaner. To provide a magnetic field perpendicular to the passage between the plasma cleaner and the vacuum chamber, the magnet is preferably oriented with the one pole facing the passage and the other pole facing away from the passage as shown in FIG. 3. The magnet may be, for example, composed of NdFeB or SmCo.

Generally, the stronger the field, the better the magnet prevents plasma from entering the microscope chamber. The maximum field strength is determined by the practical design - the space constraints and the available permanent magnets. Experiments indicate that the field generated by one NdFeB magnet of about 2 cm x 2 cm x 1 cm is sufficient for stopping the charged particles at the plasma cleaner outlet from entering the vacuum chamber, but a smaller magnet of about ½ of that size allows some of the charged particles entering the chamber.

An electromagnet with the same field orientation could also be used, but is less practical because of high currents needed to generate sufficiently strong field. Such device would certainly be much bigger and orders of magnitude more expensive.

The magnet can be used with different types of plasma generators. For example, one type of plasma cleaner is a glow discharge generator using low frequency (120 kHz) and a low power (less than about 20 W) AC power supply. The electric field generating the plasma is contained within a volume defined by the electrically conductive walls and a screen, and thus only atoms and molecules within this volume are ionized. The plasma, however, extends into the specimen chamber. The plasma can be generated e.g. from the ambient air, with the pressure reduced to a few tens of Pascals in the plasma cleaner chamber by small inlet and constant pumping of the plasma cleaner chamber through the connected vacuum chamber.

The use of a magnet to reduce the charged particles entering the vacuum chamber is applicable to any plasma cleaner in which a plasma source intended to deliver free radicals, but not ions, is spatially separated from the target vacuum chamber. A magnet can be added as a retrofit to an existing plasma cleaner. For example, the magnet can be positioned on the outside of the passage between the plasma cleaner and the vacuum chamber, and the magnetic field will penetrate the passage.

FIG. 3 shows schematically a plasma cleaner 302 connected to a vacuum chamber 304 system by a passage 306. A magnet 308 produces a magnetic field 310 that extends into passage 306, causing a Lorentz force on particles leaving plasma cleaner 302 and preventing most or all of the charged particles from entering vacuum chamber 304. (The thickness of the magnet in FIG. 3 is shown exaggerated.) Applicant has found that magnetic shielding is not typically necessary with the selected magnet size for use in scanning electron microscope or Dual Beam (FIB/SEM) system. Shielding might be desirable for some application, such as for use in smaller or more sensitive systems. Shielding could be easily implemented by using a soft magnetic material for a mesh installed at the plasma cleaner outlet.

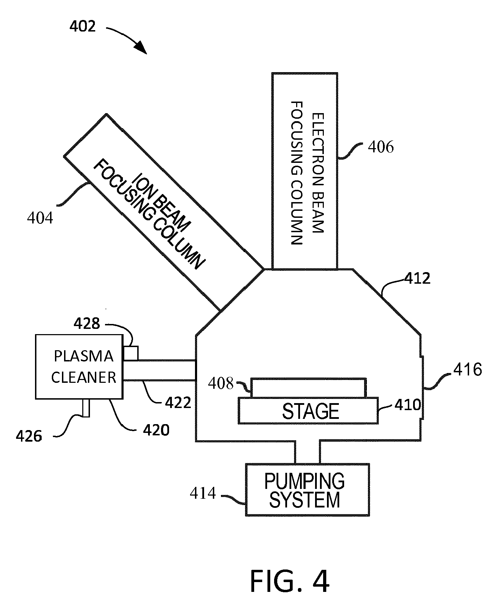

Figure 4 shows a typical dual beam (FIB/SEM) system 402. Dual beam systems are commercially available, for example, from FEI Company, Hillsboro, Oregon, the assignee of the present application Dual beam system 402 includes an ion beam focusing column 404 and an electron beam focusing column 406, both of which operate on a sample 408 positioned on a stage 410 in a sample vacuum chamber 412. A pumping system 414 evacuates sample vacuum chamber 412 after the work piece 408 is inserted through a door 416 or an air lock (not shown).

A plasma generator 420 is connected to sample vacuum chamber 412 by a passage 422 to allow selected reactive particles to pass through into chamber 412. Plasma cleaner 420 may be, for example, a glow discharge generator using a low frequency and a low power. The plasma contains electrically neutral active components such as oxygen radicals necessary for cleaning as well as detrimental electrically charged ions.

A magnet 428 is located at the outlet of plasma cleaner 420 or on passage 422 to create a magnetic field between plasma cleaner 420 and sample vacuum chamber 412. The size and strength of magnet 428 is determined by the design of the dual beam system 402, plasma cleaner 420, and other system components. The strength of the magnetic field is selected to be as strong as possible without extending too far into plasma cleaner 420 or chamber 412. The strength of the magnetic field determines the material composition of magnet 428. For example, a field generated by a NdFeB magnet is sufficient to trap the charged ions in the plasma at the outlet to plasma cleaner 420 without affecting system components in chamber 412. Magnet 428 is not limited to NdFeB and may be constructed of other materials such as, for example, SmCo. The magnetic field of magnet 428 traps and prevents ions and electrons from flowing through passage 422 and into chamber 412, which prevents secondary plasma generation in chamber 412, and thus eliminates damage to internal components of chamber 412 by contact with plasma and high voltage. The magnetic field of magnet 428 does not affect oxygen radicals which are allowed to flow through passage 422 and into chamber 412. Once inside chamber 412 the oxygen radicals combine with hydrocarbon contamination particles which are then freed to be removed from chamber 412 by vacuum pump. While FIG. 4 shows a dual beam system, embodiments of the present invention can be implemented in other types of charged particle beam systems, such as an electron beam system or an ion beam system, as well as in any other type of system in which a work piece is processed in a vacuum chamber.

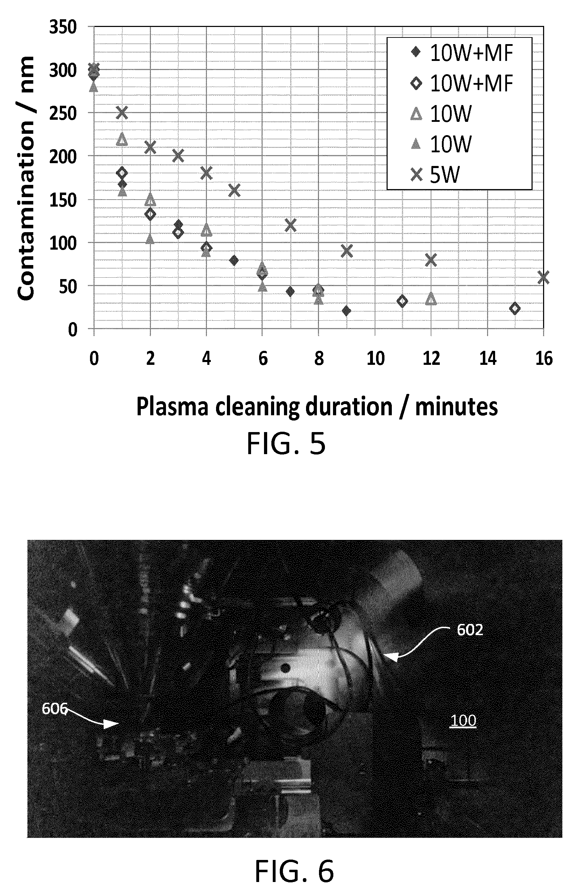

FIG. 5 shows graphs comparing the performance of a prior art plasma cleaner with a plasma cleaner modified in accordance with the invention. FIG. 5 shows the cleaning time required for a 10 W plasma cleaner with and without a magnetic field, along with a 5 W plasma cleaner for comparison. The cleaning efficiency of 10 W plasma cleaner with a magnetic field (10W + MF) is similar to the cleaning efficiency of a 10 W cleaner without a magnetic field. This shows that the magnetic field, while suppressing secondary plasmas with the vacuum chamber, does not reduce the number of reactive molecules available for cleaning the vacuum chamber. The 10 W cleaner cleans faster than the 5 W cleaner. Thus, it is possible to obtain the advantage of the higher power plasma generator without the disadvantage of secondary plasmas being created in the vacuum chamber.

FIG. 6 shows the inside of the vacuum chamber 100 of FIG. 1 during operation of a plasma cleaner (not shown) with a magnet (not shown) positioned at the output of the plasma cleaner. A plasma glow 602 is visible near the connection from the plasma generator, but there is no plasma at the work piece position 606.

Improved cleaning of a vacuum chamber by providing a magnetic field to shield plasma from a plasma source intended to deliver free radicals but not charged ions to an associated vacuum chamber is not limited to the embodiments shown and is applicable to all external plasma cleaners that are spatially separated from an associated vacuum chamber.

By "adjacent" is meant sufficiently close that a magnetic field from a magnet extends into the adjacent structure with sufficient field strength to prevent charged particle from entering the vacuum chamber. "Passage" does not imply any particular length and can be an opening between structures.

Embodiments of the invention provide an apparatus including a vacuum chamber for processing a work piece and a plasma cleaning system for cleaning the vacuum chamber, comprising:
a vacuum chamber for containing a specimen to be processed;
a plasma generator located outside the vacuum chamber and generating neutral reactive particles and charged particles;
a passage connecting the vacuum chamber and the plasma generator; and
a magnetic field source providing a magnetic field to provide a force on charged particles leaving the plasma generator to reduce the number of charged particles entering the vacuum chamber from the plasma generator while allowing reactive neutral particles to enter the vacuum chamber, the neutral reactive particles reducing contamination within the vacuum chamber.

In some embodiments, the magnetic field source is a permanent magnet.

In some embodiments, the magnetic field source is a coil.

In some embodiments, the magnetic field is sufficiently strong to prevent charged particles from the plasma generator from creating secondary plasmas within the vacuum chamber.

In some embodiments, the magnetic field is sufficiently weak to not interfere with a charged particle beam in the vacuum chamber.

In some embodiments, the magnetic field source comprises a NdFeB or SmCo magnet.

In some embodiments, the magnetic field source is positioned adjacent an outlet of the plasma generator.

In some embodiments, the magnet field source is positioned adjacent the passage and the magnetic field extends into the passage.

In some embodiments, the neutral reactive particles react with organic contaminants in the vacuum chamber to clean the interior of the vacuum chamber.

In some embodiments, the plasma generator generates oxygen radicals and ions.

In some embodiments, the plasma generator comprises a plasma chamber.

In some embodiments, the plasma generator comprises an AC glow discharged plasma generator.

In some embodiments, the plasma generator comprises an inductively coupled or capacitive coupled plasma chamber, a DC plasma generator, a microwave plasma generator or an electron cyclotron resonance plasma generator.

Some embodiments provide a cleaning system for cleaning contaminants from a vacuum chamber, comprising:
a plasma generator for generating a plasma and having an outlet through which charged particles and reactive neutral particles leave the plasma generator; and
a magnet positioned outside the plasma generator to reduce the number of charged particles entering the vacuum chamber.

Some embodiments, further comprise a passage for conducting the reactive neutral particles form the outlet to the vacuum chamber.

In some embodiments, the magnet is positioned adjacent the passage.

In some embodiments, the magnet is positioned adjacent the outlet of the plasma generator.

Some embodiments of the invention provide a method of cleaning contaminants from a vacuum chamber, comprising:
generating a plasma in a plasma generator outside of the vacuum chamber, the plasma containing neutral reactive particles and charged particles, the plasma generator having an outlet through which the neutral reactive particles and charged particles leave the vacuum chamber;
allowing neutral reactive particles and charged particles to leave the plasma generator through the outlet; and
deflecting the charged particles after they leave the outlet by using a magnetic field from a magnet positioned outside the plasma generator to prevent the charged particles from entering the vacuum chamber.

Some embodiments further comprise conducting the neutral reactive particles into the vacuum chamber to react with contamination in the vacuum chamber.

Some embodiments further comprise exhausting reaction products produced by a reaction between the neutral reactive particles and contamination within the vacuum chamber.

In some embodiments, the outlet of the plasma generator opens into a passage between the plasma generator and the vacuum chamber and in which deflecting the charged particles after they leave the outlet comprises deflecting the charged particles in the passage.

A preferred method or apparatus of the present invention has many novel aspects, and because the invention can be embodied in different methods or apparatuses for different purposes, not every aspect need be present in every embodiment. Moreover, many of the aspects of the described embodiments may be separately patentable. The invention has broad applicability and can provide many benefits as described and shown in the examples above. The embodiments will vary greatly depending upon the specific application, and not every embodiment will provide all of the benefits and meet all of the objectives that are achievable by the invention.

The terms "work piece," "sample," "substrate," and "specimen" are used interchangeably in this application unless otherwise indicated. Further, whenever the terms "automatic," "automated," or similar terms are used herein, those terms will be understood to include manual initiation of the automatic or automated process or step.

The terms "plasma generator" and "plasma chamber" are used herein to mean the same thing.

In the following discussion and in the claims, the terms "including" and "comprising" are used in an open-ended fashion, and thus should be interpreted to mean "including, but not limited to ...." To the extent that any term is not specially defined in this specification, the intent is that the term is to be given its plain and ordinary meaning. The accompanying drawings are intended to aid in understanding the present invention and, unless otherwise indicated, are not drawn to scale.

The various features described herein may be used in any functional combination or sub-combination, and not merely those combinations described in the embodiments herein. As such, this disclosure should be interpreted as providing written description of any such combination or sub-combination.

Although the present invention and its advantages have been described in detail, it should be understood that various changes, substitutions and alterations can be made to the embodiments described herein without departing from the scope of the invention as defined by the appended claims. Moreover, the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include such processes, machines, manufacture, compositions of matter, means, methods, or steps.

## Claims

1. A cleaning system for cleaning contaminants from a vacuum chamber, comprising:
a plasma generator for generating a plasma, the plasma generator having an outlet through which charged particles and reactive neutral particles leave the plasma generator;
**characterized in that**
a magnet is positioned outside the plasma generator to reduce the number of charged particles entering the vacuum chamber.

2. The cleaning system of claim 1 further comprising a passage for conducting the reactive neutral particles from the outlet to the vacuum chamber.

3. An apparatus including a vacuum chamber for processing a work piece and a plasma cleaning system for cleaning the vacuum chamber and/or the work piece, comprising:
a cleaning system in accordance with claim 1;
a vacuum chamber for containing a specimen to be processed; and
a passage connecting the vacuum chamber and the plasma generator.

4. The apparatus of any of the above claims in which the magnet is a permanent magnet.

5. The apparatus of claim 4 in which the magnet comprises a NdFeB or SmCo magnet.

6. The apparatus of any of claims 1 to 3 in which the magnet is a coil.

7. The apparatus of any of the above claims in which the magnetic is sufficiently strong to prevent charged particles from the plasma generator from creating secondary plasma sources within the vacuum chamber.

8. The apparatus of any of the above claims further comprising a charged particle beam column configured to provide a charged particle beam to operate on a work piece in the vacuum chamber and in which the magnet produces a magnetic field that is sufficiently weak so as to not interfere with the operation of the charged particle beam.

9. The apparatus of any of the above claims in which the magnet is positioned adjacent the outlet of the plasma generator.

10. The apparatus of any of claims 2 to 9 in which the magnet is positioned adjacent the passage and produces a magnetic field that extends into the passage.

11. The apparatus of any of the above claims in which the plasma generator comprises an AC glow discharged plasma generator, an RF inductively coupled or capacitive coupled plasma generators, or a DC plasma generator.

12. A method of cleaning contaminants from a vacuum chamber, comprising:
generating a plasma in a plasma generator outside of the vacuum chamber, the plasma containing neutral reactive particles and charged particles, the plasma generator having an outlet through which the neutral reactive particles and charged particles leave the vacuum chamber; and
allowing neutral reactive particles and charged particles to leave the plasma generator through the outlet;
**characterized by**
deflecting the charged particles after they leave the outlet by using a magnetic field from a magnet positioned outside the plasma generator to prevent the charged particles from entering the vacuum chamber.

13. The method of claim 12 in which deflecting the charged particles after they leave the outlet by using a magnetic field from a magnet comprises deflecting the charged particles with a magnetic field from a permanent magnet.

14. The method of claim 12 in which deflecting the charged particles after they leave the outlet by using a magnetic field from a magnet comprises deflecting the charged particles with a magnetic field from a coil.

15. The method of claim 12 in which the outlet of the plasma generator opens into a passage between the plasma generator and the vacuum chamber and in which deflecting the charged particles after they leave the outlet comprises deflecting the charged particles in the passage.
